# EUROPEAN PATENT SPECIFICATION

(11) **EP 0 466 376 B1**
(45) Date of publication and mention of the grant of the patent: **11.01.1995**
(21) Application number: 91305935.8
(22) Date of filing: 01.07.1991
(51) Int. Cl.: G02F 1/1345

(54) **Driver circuit package for liquid crystal display**
Treiberschaltungsanordnung für eine Flüssigkristallanzeigevorrichtung
Arrangement d'un circuit de commande pour un dispositif d'affichage à cristal liquide

(30) Priority: 12.07.1990 JP 182895/90
(43) Date of publication of application: 15.01.1992
(73) Proprietor: International Business Machines Corporation, Armonk, N.Y. 10504 (US)
(72) Inventor: Suzuki, Hiroshi, Fujisawa-shi, Kanagawa-ken (JP)
(74) Representative: Burt, Roger James, Dr.

(56) References cited:
- US-A- 4 586 789
- PATENT ABSTRACTS OF JAPAN vol. 10, no. 149 (P-461)(2206) 30 May 1986 & JP-A-61003126
- HITACHI REVIEW. vol. 38, no. 2, April 1989, TOKYO JP pages 109 - 114; K.SUZUKI:'TFT Addressed Liquid Crystal Color Displays'

## Description

The present invention relates to an integrated driver circuit package for a liquid crystal display and in particular to the connection of the driver circuit to pixels of the liquid crystal display.

A conventional liquid crystal display panel comprises a display section having an array of pixel electrodes mounted on a glass substrate. Panel connection electrodes are formed along the edges of the panel for connecting the pixel electrodes to driver circuitry. The panel connection electrodes are arranged to be connected to corresponding driver connection electrodes of integrated pixel driver circuit packages in the form of, for example, Tape Automated Bonding (TAB) devices. Each TAB device comprises an integrated circuit chip mounted on a tape like member carryies the tape-like member the driver connection electrodes. The driver connection electrodes are uniformly spaced along the edges of the tape like member and the panel connection electrodes are uniformly spaced along the edges of the panel. Conductive tracks interconnect corresponding driver and panel connection electrodes. The spacing between adjacent driver connection electrodes is narrower than the spacing between adjacent panel connection electrodes. Therefore, the spacings between adjacent tracks are narrower for connections between corresponding panel and driver electrodes located towards the corners of the panel than for corresponding panel and driver electrodes located towards the centres of the panel edges. There is a minimum allowable spacing between the adjacent tracks which is imposed by the liquid crystal display assembly process. The track layout required for maintaining this spacing sets the size to which the liquid crystal display can be minimised.

The article, "TFT Addressed Liquid Crystal Color Displays", Hitachi Review, vol. 38, no.2, April 1989, Tokyo JP, pages 109-114, discloses such a type of liquid crystal display.

In accordance with the present invention, there is now provided an integrated driver circuit package for a liquid crystal display or the like, the package comprising: an integrated driver circuit having outputs for driving a display section of the liquid crystal display; and a plurality of coplanar connection electrodes positioned along and extending outwardly from an edge of the package for connecting the outputs to the display section; characterised in that a spacing between adjacent connection electrodes progressively increases from the centre of the edge of the package to the ends of the edge, in such a manner that adjacent connection electrodes located at or near the centre of the edge of the package are closer together than adjacent connection electrodes located at or near an end of the edge.

This advantageously enables the driver circuit to be connected to the display section through conductive tracks that occupy less area than that required in conventional liquid crystal displays. A liquid crystal display including a driver circuit package of the present invention can therefore be made on a smaller, and thus lower cost, glass substrate.

Preferably, the package comprises a tape-like member carrying the driver circuit, the connection electrodes being disposed along an edge of the tape-like member.

This permits the manufacture of a liquid crystal display including a driver circuit package of the present invention to be automated. Furthermore, it allows such a liquid crystal display to be smaller in size.

Viewing the present invention from a second aspect, there is provided, a liquid crystal display comprising: a display section; and an integrated circuit package, the package including an integrated driver circuit having outputs for driving the display section, a plurality of coplanar connection electrodes positioned along and extending outwardly from an edge of the package for connecting the outputs to the display section; characterised in that a space separating adjacent connection electrodes progressively increases from the centre of the edge of the package to the ends of the edge, in such a manner that adjacent connection electrodes located at or near the centre of the edge of the package are closer together than adjacent connection electrodes located at or near an end of the edge.

In a preferred embodiment of the present invention, there is provided a liquid crystal display comprising: a display section; an integrated driver circuit for driving the display section; a tape like member on which the driver circuit is supported; a plurality of connection electrodes formed on the tape like member so as to be positioned along and extending outwardly from an edge of the tape like member for connecting the driver circuit to the display section; wiring means for connecting the connection electrodes to the display section; characterised in that a spacing between adjacent connection electrodes progressively increases from the centre of the edge of the tape like member to both ends of the edge.

A preferred embodiment of the present invention will now be described, by way of example only, with reference to the accompanying drawings in which:
Figure 1 is a wiring diagram of a liquid crystal panel of the present invention for the wiring of the LCD's display section and the TAB's connection electrodes.
Figure 2 is a view explaining the principle of the present invention,
Figure 3 is a view for comparing the method used in the present invention with the conventional method,
Figure 4 is a plane view of a typical LCD, and
Figure 5 is a wiring diagram of a conventional liquid crystal panel.

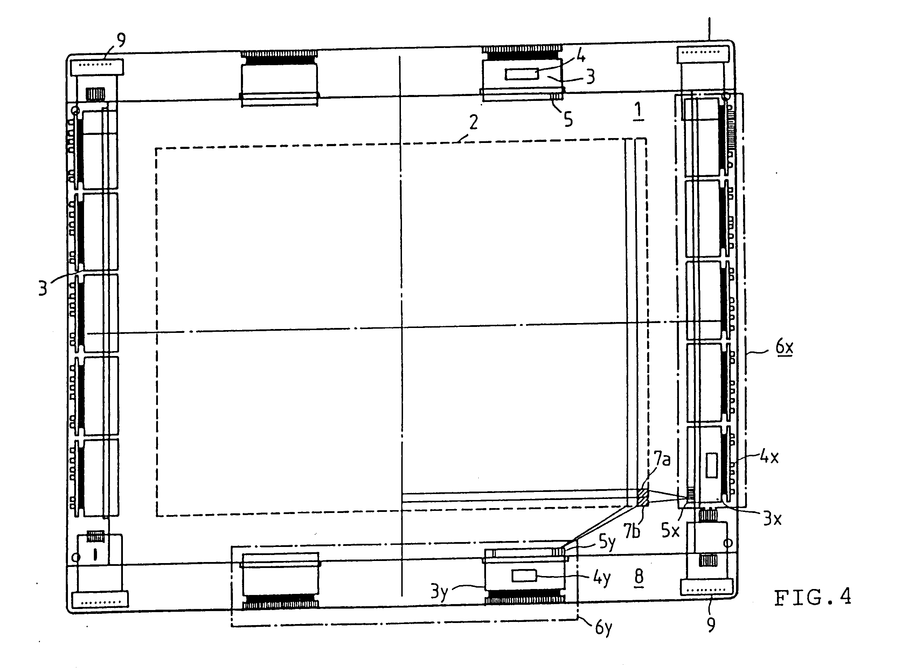

Referring first to Figure. 4 a conventional active matrix LCD comprises, a display section 2, having a large number of pixels 7a, 7b, ... and TFT elements for driving each pixel, mounted on a glass substrate 1. Connection electrodes 5 are formed at predetermined positions of both the top and bottom and the left and right of the glass substrate 1. These electrodes 5 are correspondingly connected to the connection electrodes of a tape-like member, on which a driver IC 4 is mounted. In preferred embodiments of the present invention, as a tape-like member is a TAB (Tape Automated Bonding) device. Terminals of TAB 3 are connected to a printed circuit board (PCB) 8. The PCB 8 is also supported by the glass substrate 1. Drive sections 6y, comprising of a predetermined number (two, in this figure) of TAB 3y device in the y direction, are provided on both the top and bottom sides of the display panel. Also, drive sections 6x, comprising of a predetermined number (five, in this figure) of TAB devices 3x in the x direction, are provided on both right and left sides of the display panel. At the four corners of the display panel, connectors 9 are provided to supply signals to the drive sections 6x and 6y from external circuits (not shown in the figure). Each pixel 7a, 7b ... is connected to both electrodes 5y and 5x in the y direction and x direction respectively. An enlargement of Figure. 4's example of the connection of a TAB 3 in x or y direction and the display section is shown in Figure. 5.

Conventionally, connection electrodes 5 for connecting the drive lines on the LCD's glass substrate and the driver IC, are positioned in a uniform spacing a, as shown in Figure. 5. Wiring spacing b between the connection electrodes 5 at both ends is the shortest. Therefore, when the wiring length d on the glass substrate from the display section to the connection electrodes 5 is set so that the space between at the ends will not fall below an allowance value determined liquid crystal display manufacturing process, the wiring space becomes unnecessarily wide at the centre portion of the TAB.

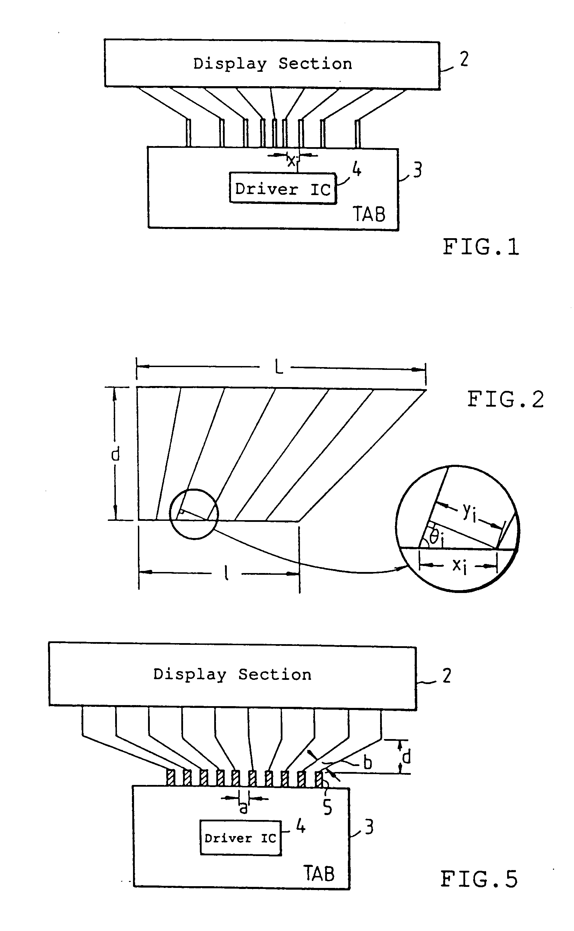

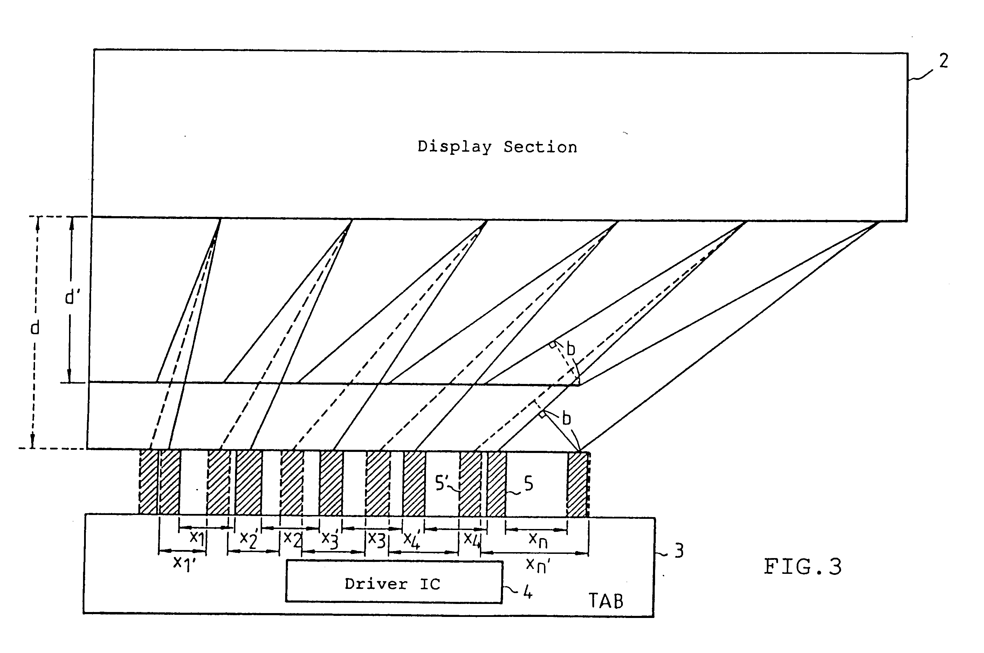

Figure. 1 shows the connection electrodes of an LCD of the present invention. The principle of the present invention explained FigureS. 2 and 3.

Referring now to Fig 2, by defining L length of the display section 2, L/n pitch between pixels, d = length of wiring on the glass substrate, Yi = minimum pitch between each wiring, Xi = space between the connection electrodes 5, Oi = angle of the wiring and connection electrode 5, and I = space between all connection electrodes, the equations shown below can be defined:

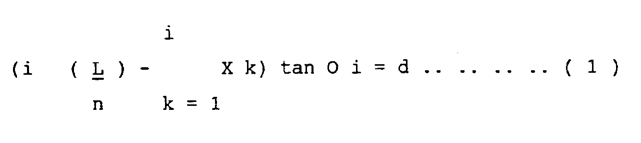

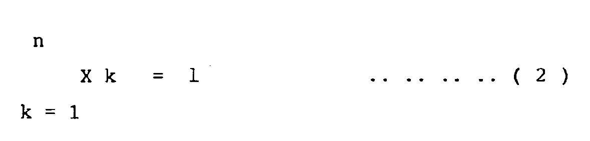

By finding the minimum value of Yi at each wiring, the following equation can be defined.

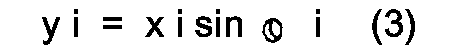

In a preferred embodiment of the present invention the pitch Xi of the connection electrodes is defined in such a manner that the minimum pitch becomes constant in i = 1, 2, ..., n. Namely,

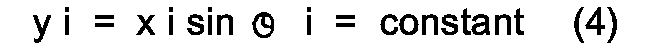

When the connection electrode pitch Xi is set to satisfy above equations (1) - (4), the wiring pitch Xi becomes wider as it reaches both ends from the centre of TAB 3 as shown in Figure. 1. Figure. 3 is a view for comparing the conventional wiring method with the invention's wiring method. In Figure. 3, the connection electrodes mounted on TAB 3 are positioned as indicated by lines, and the pitch X1-Xn of the connection electrodes are X1 = X2 = ... = Xn in the conventional method. Connection electrodes 5' are positioned as indicated by dashed lines, and the pitch X'1-X'n of the connection electrodes are X'1 < X'2 <... < X'n in the method of the invention. When wiring between the above connection electrodes and the display section, the conventional wiring method will be indicated by solid lines, and the invention's method will be indicated by dashed lines. By making the minimum wiring pitch of the invention's method equal to the minimum wiring pitch of the conventional method, it is possible to shorten the conventional length of wiring d.

The space between adjacent electrodes widen as it reaches both ends from the centre of TAB as shown in Figure. 1 when the wiring length d, the connection electrodes pitch Xi, and the minimum wiring pitch are determined as described above,

Dividing the number of connection electrodes into predetermined groups, and setting the pitch between adjacent electrodes so that the pitch at each and every wiring of each group is within the allowance range will achieve the same effect.

A practical example of a liquid crystal panel shown in Figure. 3 of the present invention, has a size of 285 mm X 230 mm, with the display section 2 is 211.2 mm X 158.4 mm in dimension.

The display section has pixel electrodes that are 0.33 mm X 0.33 mm in size. If the 35 mm TAB devices are used, the wiring length becomes 10 mm, the pitch between the connection electrodes, near the centre of TAB, is 0.15 mm, and it gradually widens as it reach both ends, so that at the ends, it become 0.33 mm.

It will be appreciated that, the present invention is not limited in application to the above values and by setting the pitch between the connection electrodes appropriately, many other values can also be obtained.

It will now be appreciated that the present invention, as hereinbefore explained, reduces the area on a glass substrate of a liquid crystal display that does not contribute to the display by arranging the connection electrodes used to connect the display section and the driver ICs in such a way that the pitch between the adjacent pixels is widened as it approach both ends of the ICs. This makes the LCD structure more compact. Additionally, by reducing the size of the required glass substrate, manufacturing costs are reduced.

## Claims

1. An integrated driver circuit package for a liquid crystal display (1) or the like, the package comprising:
an integrated driver circuit (4) having outputs for driving a display section (2) of the liquid crystal display (1); and
a plurality of coplanar connection electrodes (5) positioned along and extending outwardly from an edge of the package for connecting the outputs to the display section (2);
characterised in that a spacing between adjacent connection electrodes (5) progressively increases from the centre of the edge of the package to the ends of the edge, in such a manner that adjacent connection electrodes (5) located at or near the centre of the edge of the package are closer together than adjacent connection electrodes (5) located at or near an end of the edge.

2. A package as claimed in claim 1 comprising a tape-like member (3) carrying the driver circuit (4), the connection electrodes being disposed along an edge of the tape-like member (3).

3. A liquid crystal display (1) comprising:
a display section (2); and
an integrated circuit package, the package including an integrated driver circuit (4) having outputs for driving the display section (2), a plurality of coplanar connection electrodes (5) positioned along and extending outwardly from an edge of the package for connecting the outputs to the display section (2); characterised in that a space separating adjacent connection electrodes (5) progressively increases from the centre of the edge of the package to the ends of the edge, in such a manner that adjacent connection electrodes (5) located at or near the centre of the edge of the package are closer together than adjacent connection electrodes (5) located at or near an end of the edge.

4. A liquid crystal display (1) as claimed in claim 3, wherein adjacent connection electrodes (5) are spaced apart in such a manner that the connection electrodes (5) are divided into groups for which a corresponding spacing between printed circuit board conductors connecting the electrodes (5) to the display section (2) is within a predetermined range of values.

5. A liquid crystal display (1) as claimed in claim 3, wherein the adjacent connection electrodes (5) are spaced apart in such a manner that a corresponding spacing between printed circuit board conductors connecting the electrodes (5) to the display section has a minimum that is constant for all adjacent pairs of the electrodes (5).

6. A liquid crystal display (1) as claimed in any of claims 3-5, wherein the display section (2) comprises a plurality of pixel electrodes connected to a corresponding plurality of thin film transistors for controlling the pixel electrodes.

7. A liquid crystal display (1) as claimed in any of claims 3-6, comprising a plurality of the integrated circuit packages in row and column directions for connection to corresponding groups of row and column conductors of the display section (2).

8. A liquid crystal display (1) comprising:
a display section (2);
an integrated driver circuit (4) for driving the display section;
a tape like member (3) on which the driver circuit (4) is supported;
a plurality of connection electrodes (5) formed on the tape like member (3) so as to be positioned along and extending outwardly from an edge of the tape like member for connecting the driver circuit to the display section (2); wiring means for connecting the connection electrodes (5) to the display section (2);
characterised in that a spacing between adjacent connection electrodes (5) progressively increases from the centre of the edge of the tape like member to both ends of the edge.

## Patentansprüche

1. Integrierte Treiberschaltungsanordnung für eine Flüssigkristallanzeige (1) oder dergleichen, wobei die Anordnung folgendes beinhaltet:
eine integrierte Treiberschaltung (4) mit Ausgängen zum Ansteuern eines Anzeigebereiches (2) der Flüssigkristallanzeige (1); und
eine Mehrzahl koplanarer Verbindungselektroden (5), die entlang eines Randes der Anordnung positioniert sind und sich über ihn hinaus erstrecken, um die Ausgänge mit dem Anzeigebereich (2) zu verbinden; dadurch gekennzeichnet, daß der Abstand zwischen benachbarten Verbindungselektroden (5) stetig von der Randmitte der Anordnung bis zu den Enden des Randes hin derart anwächst, daß benachbarte Verbindungselektroden (5), die sich in oder nahe der Randmitte der Anordnung befinden, näher beieinander liegen als benachbarte Verbindungselektroden (5), die sich an einem Ende oder nahe eines Endes des Randes befinden.

2. Anordnung nach Anspruch 1, die ein streifenförmiges Element (3) beinhaltet, das den Treiberschaltkreis (4) trägt, wobei die Verbindungselektroden entlang eines Randes des streifenförmigen Elementes (3) angeordnet sind.

3. Flüssigkristallanzeige (1) mit:
einem Anzeigebereich (2); und
einer integrierten Schaltungsanordnung, wobei die Anordnung einen integrierten Treiberschaltkreis (4) mit Ausgängen zum Ansteuern des Anzeigebereiches (2) und eine Mehrzahl koplanarer Verbindungselektroden (5) beinhaltet, die entlang eines Randes der Anordnung positioniert sind und sich über ihn hinaus erstrecken, um die Ausgänge mit dem Anzeigebereich (2) zu verbinden;
dadurch gekennzeichnet, daß ein benachbarte Verbindungselektroden (5) trennender Zwischenraum stetig von der Randmitte derAnordnung bis zu den Enden des Randes hin derart anwächst, daß benachbarte Verbindungselektroden (5), die sich in oder nahe der Randmitte der Anordnung befinden, näher beieinander liegen als benachbarte Verbindungselektroden (5), die sich an einem Ende oder nahe eines Endes des Randes befinden.

4. Flüssigkristallanzeige (1) nach Anspruch 3, wobei benachbarte Verbindungselektroden (5) derart voneinander beabstandet sind, daß die Verbindungselektroden (5) in Gruppen unterteilt sind, fürdie ein entsprechender Zwischenraum zwischen den Anschlußverbindungen der Leiterplatte, welche die Elektroden (5) mit dem Anzeigebereich (2) verbinden, innerhalb eines vorgegebenen Bereiches von Werten liegt.

5. Flüssigkristallanzeige (1) nach Anspruch 3, wobei benachbarte Verbindungselektroden (5) derart voneinander beabstandet sind, daß ein entsprechenderZwischenraum zwischen den Anschlußverbindungen der Leiterplatte, welche die Elektroden (5) mit dem Anzeigebereich verbinden, ein Minimum aufweist, das für alle benachbarten Paare von Elektroden (5) konstant ist.

6. Flüssigkristallanzeige (1) nach irgendeinem der Ansprüche 3 bis 5, wobei der Anzeigebereich (2) eine Mehrzahl von Bildelement-Elektroden beinhaltet, die mit einer entsprechenden Mehrzahl von Dünnfilmtransistoren zur Steuerung der Bildelement-Elektroden verbunden ist.

7. Flüssigkristallanzeige (1) nach irgendeinem der Ansprüche 3 bis 6, die eine Mehrzahl von integrierten Schaltungsanordnungen in Zeilen- und Spaltenrichtung zurVerbindung mit entsprechenden Gruppen von Zeilen- und Spalten-Anschlußverbindungen des Anzeigebereiches (2) beinhaltet.

8. Flüssigkristallanzeige (1) mit
einem Anzeigebereich (2);
einem integrierten Treiberschaltkreis (4) zum Ansteuern des Anzeigebereiches;
einem streifenförmigen Element (3), von dem der Treiberschaltkreis (4) getragen wird;
einer Mehrzahl von Verbindungselektroden (5), die auf dem streifenförmigen Element (3) so ausgebildet sind, daß sie entlang eines Randes des streifenförmigen Elementes positioniert sind und sich über ihn hinaus erstrecken, um den Treiberschaltkreis mit dem Anzeigebereich (2) zu verbinden;
Verdrahtungsmitteln zum Verbinden der Verbindungselektroden (5) mit dem Anzeigebereich (2);
dadurch gekennzeichnet, daß ein Zwischenraum zwischen benachbarten Verbindungselektroden (5) stetig von der Mitte des Randes des streifenförmigen Elementes zu beiden Enden des Randes hin anwächst.

## Revendications

1. Boîtier de circuit d'attaque intégré pour un dispositif d'affichage à cristaux liquides (1) ou similaire, le boîtier comprenant:
un circuit (4) d'attaque intégré ayant des sorties pour l'attaque d'une partie d'affichage (2) du dispositif d'affichage (1) à cristaux liquides; et
une pluralité d'électrodes de connexion (5) coplanaires disposées le long d'un bord du boîtier et s'étendant à l'extérieur de celui-ci pour relier les sorties de la partie d'affichage (2);
caractérisé en ce qu'un espace entre les électrodes de connexion adjacentes (5) croît de manière progressive depuis le centre du bord du boîtier vers les extrémités du bord, de telle sorte que les électrodes de connexion adjacentes (5) situées au centre ou près du centre du bord du boîtier sont plus proches l'une de l'autre que les électrodes de connexion adjacentes (5) situées à une extrémité ou près d'une extrémité du bord.

2. Boîtier selon la revendication 1 comprenant un élément (1) en forme de bande portant le circuit d'attaque (4), les électrodes de connexion étant disposées le long d'un bord de l'élément (3) en forme de bande.

3. Dispositif d'affichage à cristaux liquides (1) comprenant:
une partie d'affichage (2); et
un boîtier de circuit intégré, le boîtier comportant un circuit d'attaque intégré (4) ayant des sorties pour attaquer la partie d'affichage (2), une pluralité d'électrodes de connexion coplanaires (5) disposées le long d'un bord du boîtier et s'étendant à l'extérieur de celui-ci pour connecter les sorties de la partie d'affichage (2);
caractérisé en ce qu'un espace séparant les électrodes de connexion adjacentes (5) croît progressivement depuis le centre du bord du boîtier vers les extrémités du bord, de telle sorte que les électrodes de connexion adjacentes (5) situées au centre ou près du centre du bord du boîtier sont plus proches l'une de l'autre que les électrodes de connexion adjacentes (5) situées à une extrémité du bord ou proches d'une extrémité du bord.

4. Dispositif d'affichage à cristaux liquides (1) selon la revendication 3, dans lequel les électrodes de connexion adjacentes (5) sont espacées de telle sorte que les électrodes de connexion (5) sont divisées en groupes pour lesquels un espace correspondant entre les conducteurs de la carte à circuit imprimé reliant les électrodes (5) à la partie d'affichage (2) se trouve à l'intérieur d'une plage de valeurs prédéterminée.

5. Dispositif d'affichage à cristaux liquides (1) selon la revendication 3, dans lequel les électrodes de connexion adjacentes (5) sont espacées de telle sorte qu'un espace correspondant entre les conducteurs de la carte à circuit imprimé reliant les électrodes (5) à la partie d'affichage a un minimum qui est constant pour toutes les paires adjacentes des électrodes (5).

6. Dispositif d'affichage à cristaux liquides (1) selon l'une quelconque des revendications 3-5 dans lequel la partie d'affichage (2) comporte une pluralité d'électrodes de pixels connectées à une pluralité correspondante de transistors à film mince pour la commande des électrodes de pixels.

7. Dispositif d'affichage à cristaux liquides (1) selon l'une quelconque des revendications 3-6 comprenant une pluralité de boîtiers de circuit intégré en rangées et colonnes pour la connexion à des groupes correspondants de conducteurs de rangées et de colonnes de la partie d'affichage (2).

8. Dispositif d'affichage à cristaux liquides (1) comprenant:
une partie d'affichage (2);
un circuit (4) d'attaque intégré pour attaquer la partie d'affichage;
un élément (3) en forme de bande sur lequel est supporté le circuit d'attaque (4);
une pluralité d'électrodes de connexion (5) formées sur l'élément en forme de bande (3) de manière à être disposées le long d'un bord de l'élément en forme de bande et s'étendant à l'extérieur de celui-ci pour relier le circuit d'attaque à la partie d'affichage (2); des moyens de câblage pour relier les électrodes de connexion (5) à la partie d'affichage (2);
caractérisé en ce qu'un espace entre les électrodes de connexion adjacentes (5) croît de manière progressive à partir du centre du bord de l'élément en forme de bande jusqu'aux deux extrémités du bord.
